# FASCICULE DE BREVET EUROPEEN

(11) **EP 0 496 654 B1**
(45) Date de publication et mention de la délivrance du brevet: **05.04.1995**
(21) Numéro de dépôt: 92400123.3
(22) Date de dépôt: 17.01.1992
(51) Int. Cl.: H05B 39/08, H03K 17/16, H02M 5/257

(54) **Gradateur de courant pour charge de puissance, avec pertes de filtrage réduites**
Dimmer mit minimalen Filterungsverlusten für eine Leistungslast
Dimmer for a load, with minimal filtering losses

(30) Priorité: 21.01.1991 FR 9100624
(43) Date de publication de la demande: 29.07.1992
(73) Titulaire: LEGRAND, F-87045 Limoges Cédex (FR)
(72) Inventeur: Audbert, Jean, F-06530 Peymeinade (FR)
(74) Mandataire: CABINET BONNET-THIRION

(56) Documents cités:
- WO-A-90/02473
- GB-A- 2 187 899
- GB-A- 2 228 151
- US-A- 4 591 781

## Description

L'invention se rapporte à un gradateur de courant pour charge de puissance, notamment lampe à incandescence, branchée sur un réseau à tension alternative, gradateur à insérer dans un conducteur d'alimentation de la charge par des bornes d'entrée et de sortie et comprenant un triac avec deux électrodes principales, une première connectée à la borne d'entrée et la seconde reliée à la borne de sortie, un circuit de commande émettant vers le triac un signal d'amorçage synchronisé sur la tension entre bornes avec un retard réglable, une inductance de filtrage avec une extrémité connectée à la seconde électrode du triac et une seconde extrémité reliée à la borne de sortie et un condensateur de filtrage connecté entre bornes d'entrée et de sortie. Un gradateur présentant deux triacs, dont l'un court-circuite le second, est connu du document GB-A-2 187 899. Toutefois les deux triacs sont chacun branchés en série avec l'inductance de filtrage.

En soi, les gradateurs de courant comprenant un dispositif commutateur à conduction déclenchée et un circuit de commande propre à déclencher la conduction avec un retard réglable sur le passage à zéro de la tension aux bornes du dispositif commutateur sont connus de longue date. La mise au point de dispositifs semi-conducteurs, thyristors et triacs produits en grande quantité et à faible coût a permis l'extension de l'utilisation de tels gradateurs pour des applications domestiques, tels que le réglage de l'intensité lumineuse fournie par les appareils d'éclairage, entre autres.

Le principe même de réglage de la puissance fournie à une charge de puissance par amorçage à retard réglable d'un dispositif commutateur où l'impédance de ce dispositif passe, en un temps très court devant la période de tension alternative d'alimentation d'une valeur très grande devant l'impédance de la charge à une valeur négligeable devant cette impédance, provoque des discontinuités de tension aux bornes de la charge considérables. Sans précautions particulières, surtout si la charge absorbe essentiellement de la puissance active, chaque amorçage provoque un appel-transitoire de courant sur le réseau d'alimentation. Ces transitoires constituent des parasites indésirables sur le réseau.

Aussi équipe-t-on les gradateurs de courant de cellules de filtrage de type passe-bas, constituées classiquement d'une inductance en série et d'un condensateur en parallèle sur la charge. Les valeurs de ces composants sont déterminées, compte tenu de l'impédance propre de la charge, pour que, par rapport à l'impédance de la charge, l'impédance de l'inductance soit faible à la fréquence du réseau et élevée aux fréquences des harmoniques créées par les amorçages du dispositif du commutateur tandis que pour ces mêmes fréquences, l'impédance du condensateur est respectivement élevée et faible.

Or, si les pertes aux fréquences considérées, qui s'étendent de 50Hz à quelques dizaines de kHz peuvent être négligeables pour les condensateurs, il n'en est pas de même pour les inductances dont on ne peut annuler la résistance interne, même en utilisant des bobinages sur noyaux ferromagnétiques toriques. Ces pertes représentent une part importante de la puissance dissipée par le gradateur.

Comme l'encombrement d'un composant doit croître avec la puissance qu'il dissipe, pour que sa température ne soit pas excessive, et que le prix d'une inductance est une fonction croissante de son encombrement, pour au moins les gradateurs pour appareillages grand public, l'inductance de filtrage devient le composant le plus onéreux, encombrant et dissipatif.

L'invention vise donc à réduire les pertes dans l'inductance de filtrage, pour en réduire le coût et l'encombrement, à puissance égale de la charge desservie, ou, à coût et encombrement analogues, augmenter la puissance traversante réglée.

L'invention arrive à ce résultat en offrant un gradateur de courant pour charge de puissance, notamment lampe à incandescence, branchée sur un réseau à tension alternative, gradateur à insérer dans un conducteur d'alimentation de la charge par des bornes d'entrée et de sortie et comprenant un triac avec deux électrodes principales, une première étant connectée à la borne d'entrée, un circuit de commande émettant vers le triac un signal d'amorçage synchronisé sur la tension entre lesdites bornes avec un retard réglable, une inductance de filtrage avec une première extrémité connectée à la seconde électrode principale du triac et une seconde extrémité reliée à la borne de sortie, et un condensateur de filtrage connecté entre bornes d'entrée et de sortie, caractérisé en ce qu'il comporte un second triac monté entre la borne d'entrée et la seconde extrémité de l'inductance, le circuit de commande émettant un second signal de commande vers le second triac avec un retard fixe sur le premier au moyen d'un circuit retardateur.

Les inventeurs ont pris conscience que les pertes dans l'inductance de filtrage étaient causées par le passage du courant fondamental, pour la part majeure, alors que cette inductance ne jouait un rôle favorable que dans les instants qui suivent l'amorçage du triac, où la raideur de croissance de courant est atténuée par la tension résultante entre les extrémités de l'inductance. L'amorçage du second triac, retardé par rapport à celui du triac de base, met en court-circuit le premier triac et l'inductance de filtrage en série.

En disposition préférée, le retard fixe du second signal d'amorçage par rapport au premier est supérieur à la constante de temps déterminée par la conjonction de l'inductance et du condensateur de filtrage.

La durée et la forme de la pointe de tension aux bornes de l'inductance de filtrage sont, comme on le sait, fonction de la constante de temps, déterminée par l'inductance et la capacité, de sorte que l'instant d'amorçage du second triac survient après que la pointe de tension est pour l'essentiel résorbée.

De préférence, le gradateur comprend en outre un circuit stabilisateur pour faibles charges constitué d'une cellule résistance/capacité séries montée en parallèle sur le condensateur de filtrage.

Aux faibles puissances de charge la cellule de filtrage constituée de l'inductance et du condensateur de filtrage est peu amortie ; aussi le courant en début d'amorçage du triac est en régime pseudopériodique amorti, susceptible d'entraîner un reblocage du triac. Le circuit résistance/capacité apporte un amortissement supplémentaire de sorte que le gradateur peut fonctionner correctement sur des charges plus réduites. On notera que cette particularité était connue, mais qu'elle coopère avec la disposition essentielle de l'invention pour élargir la gamme de puissance dans laquelle travaille le gradateur.

Selon une disposition préférée de l'invention, une inductance auxiliaire de valeur nettement inférieure à celle de l'inductance de filtrage, est disposée entre celle-ci et la borne de sortie. Cette inductance auxiliaire, faible et parallèlement de résistance faible, est prévue pour assurer, en coopération avec le condensateur de filtrage, un antiparasitage complémentaire du gradateur lors de l'amorçage du second triac, alors qu'une tension résiduelle persiste aux bornes du couple constitué du premier triac et de l'inductance de filtrage.

De préférence, le circuit de commande des triacs comporte un circuit d'alimentation avec une capacité réservoir apte à être chargée, à travers une diode, par la tension entre bornes d'entrée et de sortie. On obtient ainsi un dispositif où l'énergie nécessaire à l'alimentation du circuit de commande est prélevée, en série avec la charge, à partir de la tension entre bornes d'entrée et de sortie du gradateur, avant l'amorçage du premier triac. Cette disposition connue, dite parfois montage dipole, simplifie le cablâge, en supprimant la nécessité d'un couplage au réseau pour l'alimentation du circuit de commande ; elle est rendue possible par le fait que la puissance nécessaire au circuit de commande est faible, et que la tension à l'entrée du circuit d'alimentation, nécessaire pour que ce circuit fonctionne correctement, est atteinte, entre bornes d'entrée et de sortie du gradateur, pour des retards d'amorçage du premier triac par rapport aux instants de passage à zéro de la tension de réseau qui n'apportent pas de restriction perceptible de la gamme de réglage du gradateur.

Les caractéristiques et avantages de l'invention se préciseront d'ailleurs dans la description qui va suivre à titre d'exemple, en référence aux dessins annexés dans lesquels :
la figure 1 est un schéma simplifié d'un gradateur selon l'invention ;
la figure 2 est un schéma plus détaillé d'un gradateur selon l'invention.

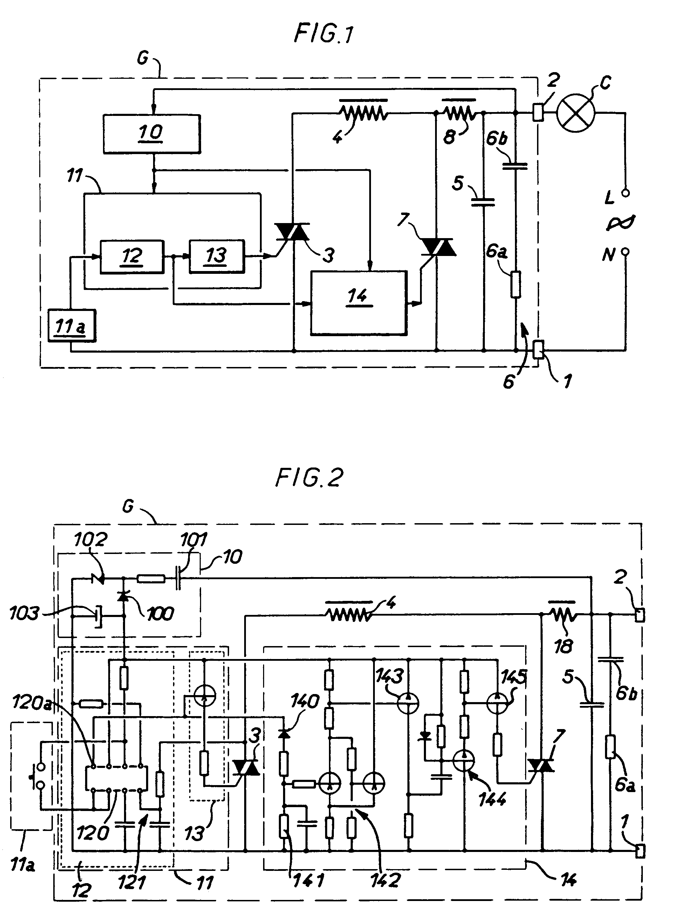

Selon le mode de réalisation choisi et représenté figure 1, un gradateur de courant G dans son ensemble est monté en série avec une charge C, telle qu'un luminaire à incandescence du type à halogènes, entre les pôles N et L d'un réseau de distribution basse tension alternative. Le gradateur G présente une borne d'entrée 1 reliée au pôle N, et une borne de sortie 2 reliée à la charge C, la borne d'entrée 1 formant conducteur de référence pour le gradateur.

Le gradateur G comporte un premier triac 3, avec une électrode principale connectée à la borne d'entrée 1, et la seconde électrode principale connectée à une extrémité d'une inductance de filtrage 4 dont l'autre extrémité est connectée à une extrémité d'une inductance auxiliaire 8, dont l'autre extrémité est connectée à la borne de sortie 2.

Entre la borne d'entrée 1 et les extrémités connectées en commun des inductances 4 et 8 est monté un second triac 7. Entre les bornes d'entrée 1 et de sortie 2 sont branchées une capacité de filtrage 5, et une cellule d'amortissement 6 composée d'une résistance 6a du côté borne d'entrée 1 et une capacité 6b côté borne de sortie 2.

Un circuit d'alimentation 10 possède une entrée reliée à la borne de sortie 2 et dessert un circuit de commande qui comporte un circuit générateur 11 de signaux d'amorçage pour le premier triac 3, avec un module de commande 11a. Le circuit générateur 11 comprend un circuit intégré 2, réalisé pour la commande d'un gradateur de l'état de la technique, qui, en réponse à des signaux de réglage provenant du module de commande, émet, en synchronisme avec la tension entre électrodes principales du triac, des impulsions à fréquence double de celle de cette tension avec un retard déterminé par les signaux de réglage. Le circuit générateur 11 comprend en outre un pilote 13 qui, en réponse aux impulsions synchronisées à retard réglé émises par le circuit intégré 12, injecte des charges sur la gâchette du triac 3 pour amorcer son état conducteur.

On notera que le triac 3, les inductances en série 4 et 8, le condensateur de filtrage 5 et la cellule d'amortissement 6, avec le circuit d'alimentation 10, le circuit générateur de signaux d'amorçage 11 associé à son module de commande 11a reproduisent un gradateur classique, à la seule différence que l'inductance de filtrage est ici divisée en deux, l'inductance 4 ayant des caractéristiques voisines de l'inductance classique.

Le triac additionnel 7, branché entre borne d'entrée 1 et point intermédiaire des inductances 4 et 8, est attaqué, sur sa gâchette par un signal d'amorçage émis par un circuit 14, qui reçoit en entrée les impulsions émises par le circuit intégré 12, et les traduit en signaux d'amorçage retardés d'une durée fixe par rapport aux impulsions; ici d'environ 250 »s.

Conformément au fonctionnement classique d'un gradateur, la manipulation convenable du mode de commande a activé le circuit intégré et a réglé le retard ajustable par rapport au passage à zéro de la tension appliquée entre électrodes principales du triac 3. Ce triac qui s'est bloqué au passage à zéro de la tension qui lui est appliquée reste bloqué, alors que la tension qui lui est appliquée commence à croître, jusqu'à ce que l'apparition d'un signal d'amorçage sur sa gâchette le rende conducteur. On remarquera que durant toute cette période, la tension entre électrodes du triac est pratiquement la tension instantanée du secteur, l'impédance de la charge C étant négligeable devant l'impédance du triac bloqué.

A l'amorçage du triac 3, la croissance du courant dans l'inductance de filtrage (ici inductance 4 plus inductance 8), ce courant étant la somme du courant de décharge de la capacité de filtrage 5, et du courant qui traverse la charge C, provoque l'apparition d'une tension entre la seconde électrode principale du triac 3 et la borne de sortie 2. Cette tension en forme d'oscillation amortie présente un flanc montant suivi d'un flanc décroissant qui se superpose à la tension créée par le courant principal, avec une pseudo période, liée à la constante de temps et dépendant des valeurs des inductances 4 + 8 et de la capacité du condensateur 5, qui est de l'ordre de 50 à 100 »s. Pratiquement au bout de 200 à 250 »s, l'élongation de cette tension transitoire s'est annulée.

Alors que dans un gradateur classique, l'inductance de filtrage reste en circuit jusqu'au blocage du triac 3 lorsque le courant dans la charge C, en fin de période du secteur, s'annule, conformément à l'invention le second triac 7 reçoit le second signal d'amorçage, retardé par rapport au premier, d'environ 250 »s soit après 2 à 5 pseudo périodes de l'ensemble de filtrage, c'est-à-dire après l'extinction pratique de la tension transitoire créée par les inductances 4 et 8. En raison de la chute de tension créée sur l'inductance principale 4, le second triac 7 s'amorce tandis que le premier triac 3 se bloque, et que le courant dans l'inductance 4 s'interrompt. L'amorçage du second triac 7 induit un accroissement de courant dans l'inductance 8, et l'apparition d'une tension transitoire sur cette inductance associée au conducteur de filtrage, pour réduire les réactions parasites sur le secteur. On rappellera que l'inductance auxiliaire 8 est nettement plus faible que l'inductance de filtrage 4, dans un rapport par exemple de 1/15. Par ailleurs, tandis que la crête de tension transitoire à l'amorçage du premier triac 3 peut atteindre 300 volts (pour une tension efficace de secteur de 200 volts) la crête de tension transitoire à l'amorçage du second triac 7 ne dépasse guère 3 volts.

La cellule d'amortissement 6, composée de la résistance 6a et du condensateur 6b est prévue pour apporter un amortissement supplémentaire au circuit oscillant constitué par les inductances 4 et 8 et le condensateur 5, lorsque l'amortissement apporté par la charge C, trop résistante, est insuffisant et que, après une demi pseudopériode du circuit peu amorti, le courant circulant dans le triac 3 entre ses électrodes principales devient inférieur au courant nécessaire à l'entretien de la décharge, et ce triac 3 se bloque. Ce blocage est aléatoire et provoque un phénomène souvent appelé "flicker" ou scintillement, par référence au régime que prend une lampe à incandescence formant charge.

La figure 2 reproduit la figure 1, en détaillant la constitution des circuits définis fonctionnellement en référence à la figure 1.

L'alimentation 10 est branchée entre bornes d'entrée 1 et de sortie 2. La tension entre ces bornes 1 et 2, qui est la tension instantanée du secteur tant que les triacs 3 et 7 ne sont pas amorcés est appliquée, à travers une capacité 101 et une résistance de limitation de courant, à une diode 100 qui charge une capacité réservoir 103. Une diode Zener 102, en parallèle sur la capacité 10J fixe la valeur de la tension redressée d'alimentation des divers circuits.

Le circuit intégré 120, associé à un module de commande 11a, est un dispositif classique pour la commande de variateur à triac. Il délivre, sur sa sortie 120a des impulsions à fréquence double de celles du secteur, synchronisées sur la tension appliquée au triac 3 et prélevée par la cellule RC 121. Par des contacts fugitifs appropriés sur le bouton poussoir du module de commande 11a on obtient l'apparition des impulsions synchronisées, la variation du retard de ces impulsions sur le passage à zéro de la tension sur le triac 3, et leur suppression.

Les impulsions issues de la sortie 120a du circuit intégré 120 sont appliquées à un circuit pilote 13, constitué d'un transistor monté en émetteur suiveur relié à la gâchette du triac 3.

Ces impulsions sont également appliquées à un circuit retardateur 14, à travers une diode 140, à un intégrateur RC 141, dont la constante de temps correspond au retard voulu pour l'amorçage du second triac 7. Pour un retard de 250 »s, la constante de temps sera de 150 »s environ.

Les impulsions intégrées sont appliquées à une bascule 142, constituée de deux transistors à émetteurs reliés et couplage du collecteur de l'un à la base de l'autre. Cette bascule émet un signal rectangulaire de durée 250 »s en réponse à chaque impulsion intégrée.

Ce signal est appliqué, à travers un étage séparateur 143, à un différenciateur 144 asymétrique, qui émet une impulsion en réponse au seul front arrière du signal rectangulaire mis en forme par la bascule 142. Cette impulsion est appliquée à un transistor 145 monté en pilote, analogue au pilote 13, pour commander l'amorçage du triac 7.

Bien entendu, l'invention n'est pas limitée aux exemples décrits, mais en embrasse toutes les variantes d'exécution, dans le cadre des revendications.

Notamment les structures du circuit retardateur 14 et des circuits de commande de retard variable 11, peuvent être quelconques dès lors qu'elles assurent des fonctions analogues. Bien que l'alimentation 10 ait l'avantage de ne pas nécessiter de liaison particulière au secteur, il va de soi qu'une alimentation branchée sur le secteur ne changerait rien à l'essentiel de l'invention. Enfin, dans la mesure où la tolérance sur le niveau de parasites renvoyée vers le secteur n'est pas serrée, l'inductance 8 peut être supprimée.

Par ailleurs, on notera que les inductances 4 et 8 peuvent être bobinées sur un même noyau, la connexion du triac 7 se faisant sur un point intermédiaire approprié du bobinage.

## Revendications

1. Gradateur de courant pour charge de puissance (C), notamment lampe à incandescence, branchée sur un réseau à tension alternative, gradateur (6) à insérer dans un conducteur d'alimentation de la charge par des bornes d'entrée (1) et de sortie (2) et comprenant un triac (3) avec deux électrodes principales, une première étant connectée à la borne d'entrée (1), un circuit de commande (11) émettant vers le triac un signal d'amorçage synchronisé sur la tension entre lesdites bornes (1, 2) avec un retard réglable, une inductance de filtrage (4) avec une première extrémité connectée à la seconde électrode principale du triac (3) et une seconde extrémité reliée à la borne de sortie (2), et un condensateur de filtrage (5) connecté entre bornes d'entrée (1) et de sortie (2), caractérisé en ce qu'il comporte un second triac (7) monté entre la borne d'entrée (1) et la seconde extrémité de l'inductance (4), le circuit de commande (11) émettant un second signal de commande vers le second triac (7) avec un retard fixe sur le premier (3) au moyen d'un circuit retardateur (14).

2. Gradateur selon la revendication 1, caractérisé en ce que, l'inductance (4, 8) et le condensateur de filtrage (5) déterminant conjointement une constante de temps, le retard fixe est supérieur à celle-ci.

3. Gradateur selon l'une des revendications 1 et 2, caractérisé en ce qu'il comprend en outre un circuit stabilisateur (6) pour faible charge constitué d'une cellule résistance (6a) capacité (6b) séries montée en parallèle sur le condensateur de filtrage (5).

4. Gradateur selon une quelconque des revendications 1 et 2, caractérisé en ce qu'une inductance auxiliaire (8) de valeur nettement inférieure à celle de l'inductance de filtrage (4) est disposée entre celle-ci et la borne de sortie (2).

5. Gradateur selon une quelconque des revendications 1 à 4, caractérisé en ce que le circuit de commande (11) des triacs (3, 7) comporte un circuit d'alimentation (10) avec une capacité réservoir (103) apte à être chargée, à travers une diode (100), par la tension entre bornes d'entrée (1) et de sortie (2).

## Patentansprüche

1. Dimmer für eine Leistungslast (C), insbesondere Glühlampe, welche an ein Wechselspannungsnetz angeschlossen ist, wobei der Dimmer (6) über eine Eingangsklemme (1) und eine Ausgangsklemme (2) in eine Versorgungsleitung der Last einsetzbar ist und ein Triac (3) mit zwei Hauptelektroden aufweist, von denen eine erste an die Eingangsklemme (1) angeschlossen ist, mit einem Steuerkreis (11), der an das Triac ein Zündsignal mit einstellbarer Verzögerung sendet, welches mit der Spannung zwischen den genannten Klemmen (1, 2) synchronisiert ist, mit einer Filterinduktivität (4), die mit einem ersten Ende an die zweite Hauptelektrode des Triacs (3) angeschlossen ist und mit einem zweiten Ende mit der Ausgangsklemme (2) verbunden ist, und mit einer Filterkapazität (5), die zwischen die Eingangs- und die Ausgangsklemme geschaltet ist,
dadurch **gekennzeichnet**,
daß der Dimmer ein zweites Triac (7) aufweist, welches zwischen die Eingangsklemme (1) und das zweite Ende der Induktivität (4) geschaltet ist, wobei der Steuerkreis (11) mittels einer Verzögerungsschaltung (14) ein zweites Steuersignal an das zweite Triac (7) sendet mit einer festen Verzögerung zum ersten Triac (3).

2. Dimmer nach Anspruch 1,
dadurch **gekennzeichnet**,
daß die Filterinduktivität (4, 8) und die Filterkapazität (5) gemeinsam eine Zweitkonstante bestimmen und daß die feste Verzögerung größer ist als diese.

3. Dimmer nach Anspruch 1 oder 2,
dadurch **gekennzeichnet**,
daß der Dimmer desweiteren eine Stabilisierungsschaltung (6) für kleine Lasten aufweist, die aus einem Widerstands(6a)-Kapazitäts(6b)-Reihenglied besteht, welches parallel zur Filterkapazität (5) geschaltet ist.

4. Dimmer nach Anspruch 1 oder 2,
dadurch **gekennzeichnet**,
daß eine Hilfsinduktivität (8) mit einem deutlich geringeren Wert als derjenige der Filterinduktivität (4) zwischen dieser und der Ausgangsklemme (2) angeordnet ist.

5. Dimmer nach einem der Ansprüche 1 bis 4,
dadurch **gekennzeichnet**,
daß der Steuerkreis (11) der Triacs (3, 7) eine Versorgungsschaltung (10) aufweist mit einer Speicherkapazität (103), die über eine Diode (100) von der Spannung zwischen Eingangsklemme (1) und Ausgangsklemme (2) aufladbar ist.

## Claims

1. A current dimmer for a power load (C), in particular an incandescent lamp, which is connected to an ac voltage system, which dimmer (6) is to be fitted into a conductor for supplying the load by input and output terminals (1, 2 respectively) and comprising a triac (3) with two main electrodes, a first one being connected to the input terminal (1), a control circuit (11) for emitting towards the triac a starting signal which is synchronised on the voltage between said terminals (1, 2) with a regulatable delay, a filtering inductor (4) with a first end connected to the second main electrode of the triac (3) and a second end connected to the output terminal (2), and a filtering capacitor (5) connected between the input and output terminals (1, 2), characterised in that it comprises a second triac (7) disposed between the input terminal (1) and the second end of the inductor (4), the control circuit (11) emitting a second control signal towards the second triac (7) with a fixed delay in relation to the first (3), by means of a delay circuit (14).

2. A dimmer according to claim 1 characterised in that, the inductor (4, 8) and the filtering capacitor (5) jointly defining a time constant, the fixed delay is greater than same.

3. A dimmer according to one of claims 1 and 2 characterised in that it further comprises a stabiliser circuit (6) for a low load, which is formed by a series resistor (6a)-capacitor (6b) cell disposed in parallel with the filtering capacitor (5).

4. A dimmer according to either one of claims 1 and 2 characterised in that an auxiliary inductor (8) of a value which is markedly less than that of the filtering inductor (4) is disposed between same and the output terminal (2).

5. A dimmer according to any one of claims 1 to 4 characterised in that the control circuit (11) for the triacs (3, 7) comprises a supply circuit (10) with a storage capacitor (103) which can be charged through a diode (100) by the voltage across the input and output terminals (1, 2).
